# EUROPEAN PATENT APPLICATION

(11) **EP 1 267 416 A1**
(43) Date of publication of application: **18.12.2002**
(21) Application number: 01999009.2
(22) Date of filing: 28.11.2001
(51) Int. Cl.: H01L 29/788, H01L 27/115, H01L 21/8247

(54) **NONVOLATILE STORAGE DEVICE AND METHOD FOR MANUFACTURING NONVOLATILE STORAGE DEVICE**

(30) Priority: 29.11.2000 JP 2000362215
(71) Applicant: Sony Corporation, Tokyo 141-0001 (JP)
(72) Inventor: SUZUKI, Toshiharu, Shinagawa-ku, Tokyo 141-0001 (JP)
(74) Representative: Müller - Hoffmann & Partner
(86) International application number: JP0110395
(87) International publication number: WO02045175

(57) **Abstract**

While maintaining sufficient density of stored charges, data retention time, and endurance characteristics of write/erase in a nonvolatile memory element, a write voltage may be decreased and the element itself may be miniaturized. A nonvolatile memory element (1) is configured by forming a tunnel oxide film (5) on a Si substrate (2) to be a base; forming, on the tunnel oxide film (5), a floating gate electrode (6) having a hemisphere polysicon on its own surface; forming a highly even interlayer dielectric (7) on the floating gate electrode (6) having an irregular shape; and forming a control electrode (8) on the interlayer dielectric (7).

## Description

### TECHNICAL FIELD

The present invention relates to a nonvolatile memory element retaining data regardless of whether its power supply is on or off and a method of manufacturing the nonvolatile memory element, and in particular to a nonvolatile memory element configured to be of FG type and a method of manufacturing the nonvolatile memory element.

### BACKGROUND ART

As for MIS (Metal Insulated Semiconductor) type LSI's, many nonvolatile memory elements capable of retaining data regardless of whether power supplies thereof are on or off have been used as memory elements to retain data. Examples of such nonvolatile memory elements are typically an FG (Floating Gate) type nonvolatile memory element and a MONOS (Metal - Si oxide film - Si nitride film - Si substrate) type nonvolatile memory element. Both elements charge to store information in a given method.

At first, a process of manufacturing an FG type nonvolatile memory element of a conventional design will be described hereafter.

Such an FG type nonvolatile memory element is configured to provide a floating gate electrode of polycrystalline Si, for example, in an intermediate position within a gate insulating film of an MIS type transistor. By charging the floating gate electrode, a threshold of the MIS type transistor is changed so as to store information.

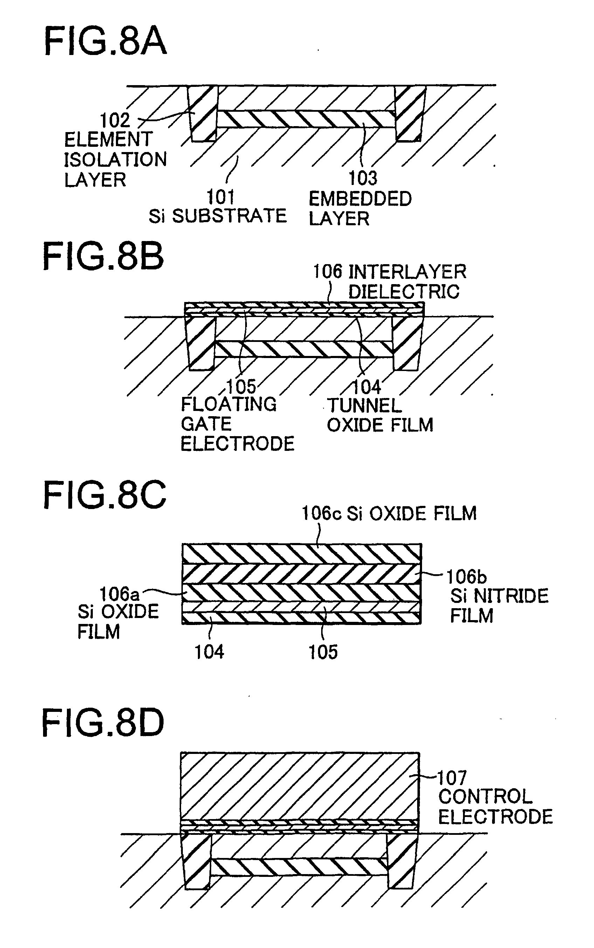

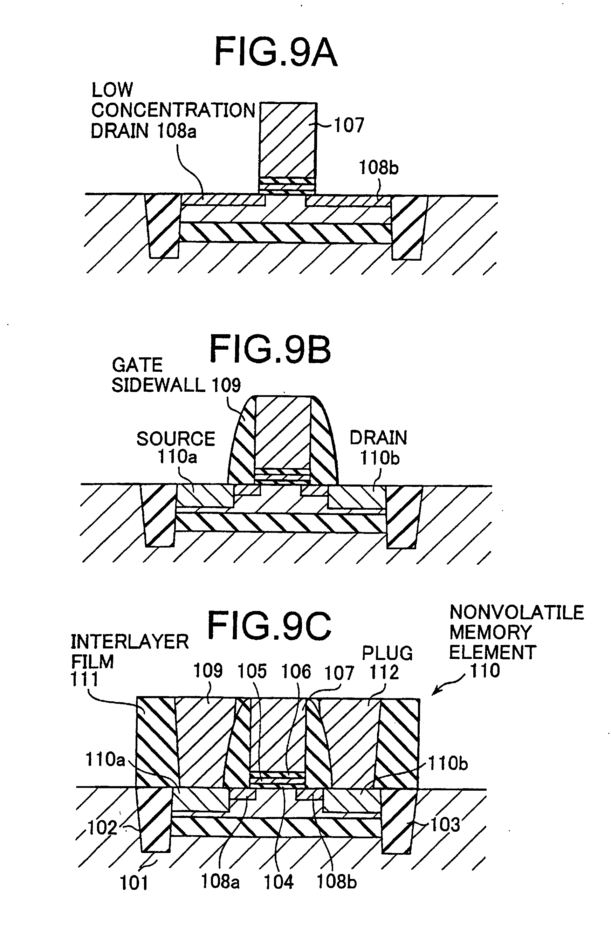

Figs. 8A to 8D and Figs. 9A to 9C are cross-sectional views for explaining a process of manufacturing an FG type nonvolatile memory element 100 of a conventional design.

When manufacturing the FG type nonvolatile memory element 100, firstly, as shown in Fig. 8A, an element isolation layer 102 is formed in a Si substrate 101 by means of shallow trench isolation and the like, then an embedded layer 103 for adjusting a threshold voltage is formed by means of a conventional ion implantation process.

Next, the Si substrate 101 is thermally oxidized at about 800°C for about 15 minutes so that, as shown in Fig. 8B, a tunnel oxide film 104 having a thickness of about 8 nm is formed on a surface of the Si substrate 101. Then, a floating gate electrode 105 is formed on a surface thereof to have a thickness of about 6 nm, further an interlayer dielectric 106 is formed on a surface thereof.

Fig. 8C is an enlarged view showing a detailed construction of the tunnel oxide film 104, the floating gate electrode 105 and the interlayer dielectric 106 which are configured as described above. As shown in Fig. 8C, the interlayer dielectric 106 has a three-layer construction of a Si oxide film 106a, a Si nitride film 106b and a Si oxide film 106c. The Si oxide film 106a is formed by performing thermal oxidation on a surface of the floating gate electrode 105 at about 850°C for about 10 minutes so as to have a thickness of about 5 nm. The Si nitride film 106b is formed by conventional processes such as an LP-CVD, plasma CVD on a surface of the Si oxide film 106a such that the Si nitride film 106b may be deposited up to about 12 nm. The Si oxide film 106c is formed by thermal oxidation of a surface of the Si nitride film 106b so as to have a thickness of about 6 nm.

After formation of the interlayer dielectric 106, as shown in Fig. 8D, a control electrode 107 is formed of polycrystalline Si, WSi, etc. including a high concentration of phosphorus and the like, then patterned by means of a conventional lithographic technology and an RIE technology so as to be the control electrode 107 as shown in Fig. 9A. Further, using the patterned control electrode 107 as a mask, impurities such as phosphorus, arsenic, etc. are implanted by an ion implantation process at a concentration of 5 × 10¹³ /cm², for example, so as to form low concentration drains 108a and 108b.

Then, as shown in Fig. 9B, gate sidewalls 109 are formed by means of conventional CVD and etch back processes. Using the gate sidewalls 109 as masks, impurities such as phosphorus, arsenic, etc. are implanted by an ion implantation process at a concentration of 5 × 10¹⁵ /cm², for example, so as to form a source 110a and a drain 110b.

Finally, in order to activate the implanted impurities, heat treatment at about 900°C for about 30 minutes by means of a conventional electric heating furnace or heat treatment at about 1050°C for 10 seconds by means of rapid thermal processing (RTP) is carried out to form an interlayer film 111 of Si oxide film etc. and a plug 112 of W or polycrystalline Si to thereby construct the nonvolatile memory element 100 as shown in Fig. 9C.

As to the nonvolatile memory element 100, a voltage of about + 20 V is applied to the control electrode 107 in a situation where the Si substrate 101 is grounded so that, through a conduction channel area of the Si substrate 101, charges are injected into and stored in the floating gate electrode 105 by employing FN tunnel current or the like. In the state of the stored charges, a threshold voltage of the MIS type transistor is high. The state of the stored charges is maintained even after the voltage application to the control electrode 107 has been stopped. Thus, the nonvolatile memory element 100 can retain data regardless of whether power supply for the element is on or off.

Next, a manufacturing process of a MONOS type nonvolatile memory element, of a conventional design, will be described.

The MONOS type nonvolatile memory element has layers comprised of metal- Si oxide film - Si nitride film - Si oxide film - Si substrate. Charges are stored in discrete traps which are in the Si nitride film and near the boundary of the Si oxide film and the Si nitride film so as to change threshold values of transistors and to retain data (IE3 Trans, Electron Dev. ED39(2), 122(1983)).

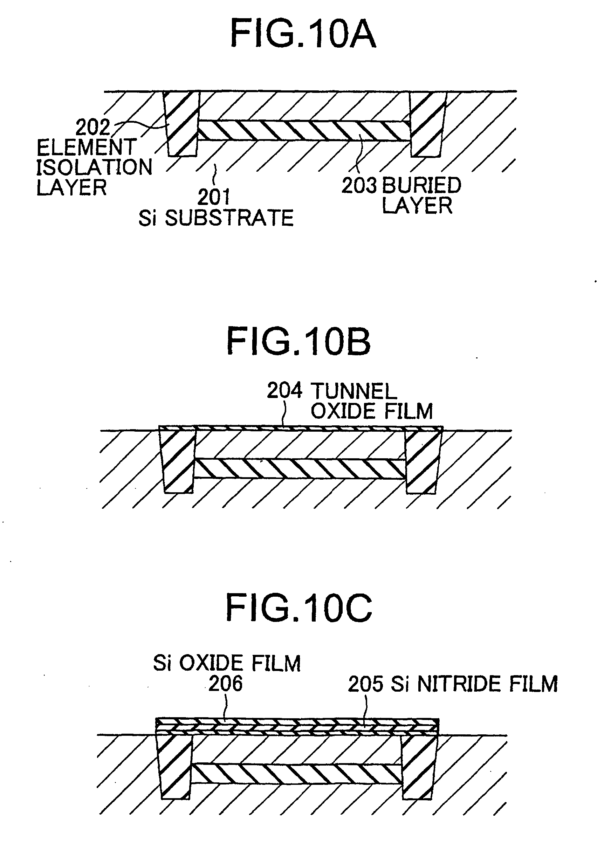

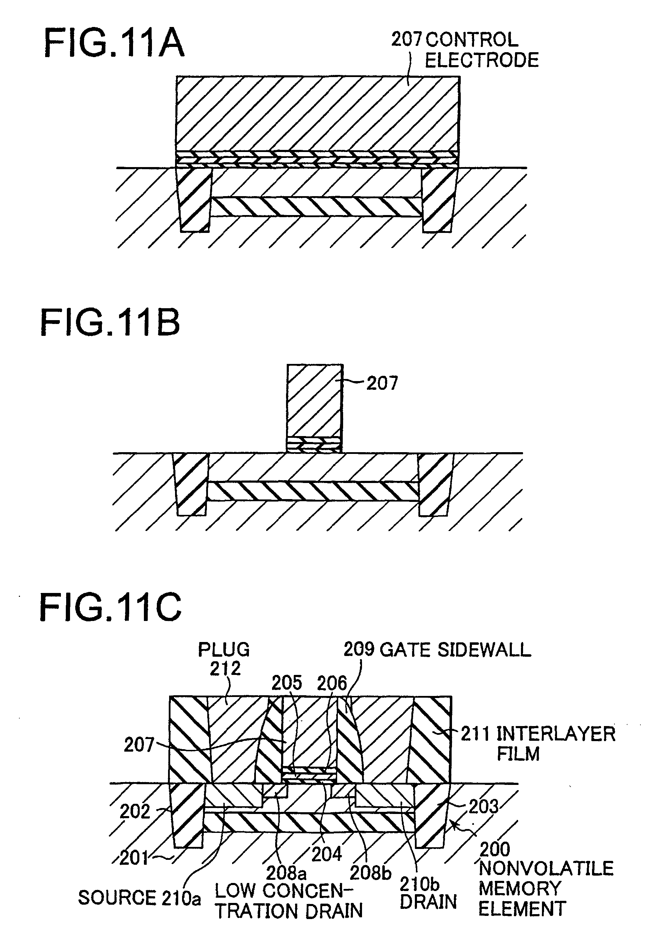

Figs. 10A to 10C and Figs. 11A to 11C are cross-sectional views for explaining a process of manufacturing a MONOS type nonvolatile memory element 200.

When manufacturing the MONOS type nonvolatile memory element 200, firstly, as shown in Fig. 10A, an element isolation layer 202 is formed in a Si substrate 201 by means of shallow trench isolation and the like, then an embedded layer 203 for adjusting a threshold voltage is formed by means of a conventional ion implantation process.

Next, the Si substrate 201 is thermally oxidized at about 800°C for about 15 minutes so that a tunnel oxide film 204, about 3 nm thick, is formed on a surface of the Si substrate 201. Then, a Si nitride film 205 is formed on a surface thereof by means of conventional processes such as an LP-CVD, a plasma CVD so as to have a thickness of about 8 nm. Then, the Si nitride film 205 is oxidized again in order to form a Si oxide film 206 of about 3 to 5 nm.

After formation of the Si oxide film 206, as shown in Fig. 11A, a control electrode 207 is formed of polycrystalline Si, WSi, etc. including a high concentration of phosphorus and the like, then patterned by means of conventional lithographic technology and RIE technology so as to be the control electrode 207 as shown in Fig. 11B.

Further, using the patterned control electrode 207 as a mask, impurities such as phosphorus, arsenic, etc. are implanted by an ion implantation process at a concentration of 5 × 10¹³ /cm², for example, so as to form low concentration drains 208a and 208b as shown in Fig. 11C.

Then, gate sidewalls 209 are formed by means of conventional CVD and etch back processes. Using the gate sidewalls 209 as masks, impurities such as phosphorus, arsenic, etc. are implanted by an ion implantation process at a concentration of 5 × 10¹⁵ /cm², for example, so as to form a source 210a and a drain 210b.

Finally, in order to activate the implanted impurities, heat treatment at about 900°C for about 30 minutes by means of a conventional electric heating furnace or heat treatment at about 1050°C for 10 seconds by means of rapid thermal processing (RTP) is carried out to form an interlayer film 211 of Si oxide film etc. and a plug 212 of W or polycrystalline Si to thereby construct the nonvolatile memory element 200.

As to the nonvolatile memory element 200 as formed in the manner described above, traps to store charges are formed in the Si nitride film 205 itself and in a SiON transition layer located near the boundary of the Si oxide film 206 and the Si nitride film 205; the charges are discretely stored in the traps so as to retain data regardless of whether power supply for the element is on or off.

In the conventional FG type nonvolatile memory element 100, however, if a leakage between the floating gate electrode 105 and the Si substrate 101 occurs, all charges stored at the floating gate electrode 105 are lost, so that it is very difficult to make the tunnel oxide film 104 thin. Thus, a problem arises in that, when injecting charges from the channel area of the Si substrate 101 to the floating gate electrode 105, a required applying voltage between the Si substrate 101 and the floating gate electrode 105 should be increased, and a data write voltage to be applied to the whole nonvolatile memory element 100 should be also increased.

Still another problem arises in that when the data write voltage is increased, in order to ensure a sufficient withstanding voltage of the drain 110b, it may be hard to make the drain 110b fine, and the nonvolatile memory element 100 may not be miniaturized.

Further, since the MONOS type nonvolatile memory element 200 discretely stores charges in traps which are in the tunnel oxide film 204 and the SiON transition layer near the boundary between the Si oxide film 206 and Si nitride film 205 so as to retain data, a partial leakage at the tunnel oxide film 204 does not lose all the charges stored in the traps. Therefore, the tunnel oxide film 204 may have a small thickness so that a data write voltage may be reduced and the element may be miniaturized compared with the FG type nonvolatile memory element 100.

However, a trap density of the MONOS type nonvolatile memory element 200 is not sufficiently high. A density of charges to be stored is lower, by about five digits, than that of the FG type nonvolatile memory element 100.

Further, with respect to the MONOS nonvolatile memory element 200, it is not easy to form its traps to allow a good reproducibility of the density and a good controllability. There may be introduced a problem that the nonvolatile memory element 200 of a fine structure does not provide sufficient data retention time or sufficient endurance characteristics of write/erase.

In view of the above problems, the present invention has been made so as to provide a nonvolatile memory element which ensures sufficient density of stored charges, data retention time, and endurance characteristics of write/erase, and at the same time enables a write voltage to decrease and the element itself to be smaller, and to provide a method of manufacturing the nonvolatile memory element.

### DISCLOSURE OF THE INVENTION

In order to solve the problems as described above, the present invention provides, in a nonvolatile memory element which retains data regardless of whether power supply for the element is on or off, the nonvolatile memory element characterized by comprising a semiconductor substrate to be a base; a tunnel oxide film formed on the semiconductor substrate; a floating gate electrode formed on the tunnel oxide film so as to have an irregular shape on its own surface; an interlayer dielectric formed on the floating gate electrode; and a control electrode formed on the interlayer dielectric.

In the nonvolatile memory element, the surface of the floating gate electrode is formed to have the irregular shape so that a surface area of the floating gate electrode is larger, whereby a static capacity between the control electrode and the floating gate electrode can be increased. Thus, a ratio (a coupling ratio) of the static capacity between the control electrode and the floating gate electrode to the whole static capacity of the floating gate electrode can be increased so that an applied voltage between the semiconductor substrate and the floating gate electrode can be increased without increasing a voltage applied to the whole nonvolatile memory element.

Further, in the nonvolatile memory element according to the present invention, the irregular shape of the floating gate electrode may preferably be in an irregular shape on a substantially hemisphere.

Furthermore, in the nonvolatile memory element according to the present invention, the irregular shape of the floating gate electrode is preferably formed so that a grain size may be 10 nm to 20 nm.

Still further, in the nonvolatile memory element according to the present invention, the interlayer dielectric is preferably formed by means of an atomic layer chemical vapor deposition process.

Further, in the nonvolatile memory element according to the present invention, the floating gate electrode and the interlayer dielectric are preferably formed so as to surround a bottom surface and sidewalls of the control electrode.

The nonvolatile memory element according to the present invention is preferably for a flash memory.

In addition, there is provided, in a method of manufacturing a nonvolatile memory element which retains data regardless of whether power supply for the element is on or off, the method characterized by comprising a tunnel oxide film forming step of forming a tunnel oxide film on a Si substrate to be a base; a floating gate electrode forming step of forming, on the tunnel oxide film, a floating gate electrode having a surface of an irregular shape; an interlayer dielectric forming step of forming an interlayer dielectric on the floating gate electrode; a control electrode forming step of forming a control electrode on the interlayer dielectric.

Herein, the surface of the floating gate electrode is formed in the irregular shape so that a surface area of the floating gate electrode is larger, whereby a static capacity between the control electrode and the floating gate electrode can be increased. Thus, a ratio (a coupling ratio) of the static capacity between the control electrode and the floating gate electrode to the whole static capacity of the floating gate electrode can be increased so that an applied voltage between the semiconductor substrate and the floating gate electrode can be increased without increasing a voltage applied to the whole nonvolatile memory element.

Further, in the method of manufacturing the nonvolatile memory element according to the present invention, the interlayer dielectric is preferably formed by means of an atomic layer chemical vapor deposition process in the interlayer dielectric forming step.

The method of manufacturing the nonvolatile memory element according to the present invention preferably further comprises, in order to form a gate electrode, a gate electrode etching step of etching the tunnel oxide film, the floating gate electrode, the interlayer dielectric and the control electrode respectively formed by the tunnel oxide film forming step, the floating gate electrode forming step, the interlayer dielectric forming step and the control electrode forming step.

Further, the method of manufacturing the nonvolatile memory element according to the present invention preferably further comprises a dummy gate electrode forming step of forming a dummy gate electrode on the tunnel oxide film subsequent to the tunnel oxide film forming step; a dummy gate electrode etching step of etching the dummy gate electrode; a gate sidewall forming step of covering a sidewall of the dummy gate electrode with a gate sidewall; a dummy gate electrode removing step of removing the dummy gate electrode subsequent to forming the gate sidewall. In the floating gate electrode forming step, the floating gate electrode is formed along an inner sidewall of the gate sidewall. In the interlayer dielectric forming step, the interlayer dielectric is formed along an inner sidewall of the floating gate electrode.

### BRIEF DESCRIPTION OF THE DRAWINGS

Figs. 1A to 1B are structural views showing a structure of a nonvolatile memory element.
Figs. 2A to 2C are cross-sectional structural views for explaining a process of manufacturing the nonvolatile memory element.
Figs. 3A to 3C are cross-sectional structural views for explaining the process of manufacturing the nonvolatile memory element.
Figs. 4A to 4B are structural views showing a structure of a nonvolatile memory element.
Figs. 5A to 5C are cross-sectional structural views for explaining a process of manufacturing the nonvolatile memory element.
Figs. 6A to 6C are cross-sectional structural views for explaining a process of manufacturing the nonvolatile memory element.
Figs. 7A to 7C are cross-sectional structural views for explaining the process of manufacturing the nonvolatile memory element.
Figs. 8A to 8D are cross-sectional structural views for explaining the process of manufacturing an FG type nonvolatile memory element of a conventional structure.
Figs. 9A to 9C are cross-sectional structural views for explaining the process of manufacturing an FG type nonvolatile memory element of a conventional structure.
Figs. 10A to 10C are cross-sectional structural views for explaining a process of manufacturing a MONOS type nonvolatile memory element.
Figs. 11A to 11C are cross-sectional structural views for explaining the process of manufacturing the MONOS type nonvolatile memory element.

### BEST MODE FOR CARRYING OUT THE INVENTION

With reference to the drawings, embodiments of the present invention will be described hereafter.

Firstly, a first embodiment according to the present invention will be described.

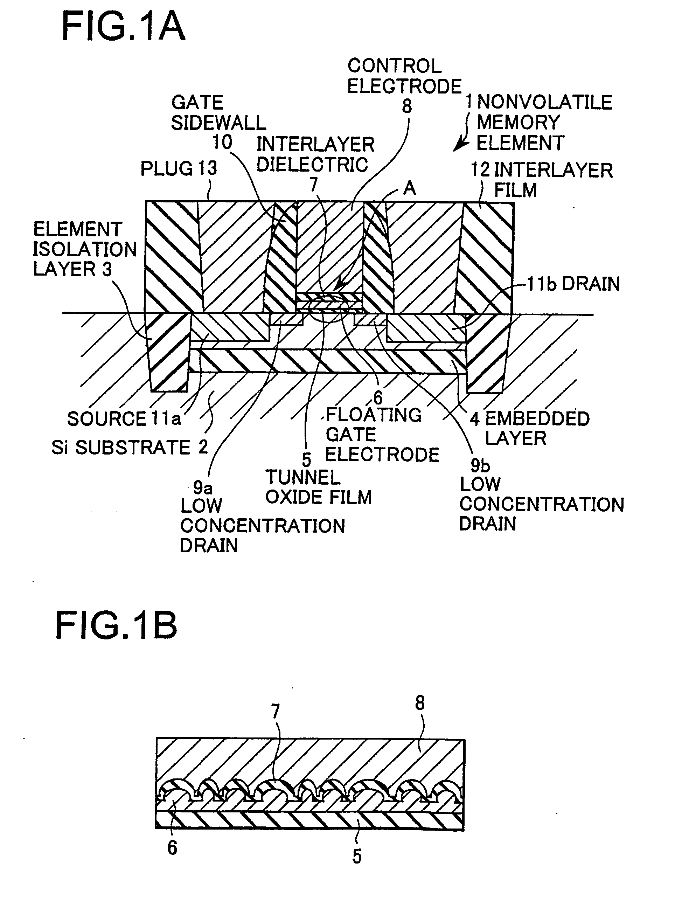

Figs. 1A to 1B are structural views showing a structure of a nonvolatile memory element 1. Fig. 1A shows a cross-sectional view of the nonvolatile memory element 1, and Fig. 1B shows an enlarged cross-sectional view of a portion A in Fig. 1A.

The nonvolatile memory element 1 is an FG type nonvolatile memory element which is utilized as a flash memory, for example, and is mainly comprised of a Si substrate 2 which is a semiconductor substrate to be a base; an element isolation layer 3; an embedded layer 4 provided in the Si substrate 2 so as to adjust a threshold voltage; a tunnel oxide film 5 formed on the Si substrate 2; a floating gate electrode 6 formed on the tunnel oxide film 5 so as to have an irregular shape on its own surface; an interlayer dielectric 7 formed on the floating gate electrode 6; a control electrode 8 provided on the interlayer dielectric 7; low concentration drains 9a and 9b formed at a surface of the Si substrate 2; a source 11a; a drain 11b; a gate sidewall 10 formed on an upper surface of the Si substrate 2; an interlayer film 12; and a plug 13.

As shown in Fig. 1B, the floating gate electrode 6 of the nonvolatile memory element 1 is formed to have the irregular shape on its own surface so that a surface area of the floating gate electrode 6 is increased and a static capacity between the floating gate electrode 6 and the control electrode 8 can be increased. The irregular shape may be of a substantial hemisphere such as a mushroom shape, a waveform, or any other rugged shape, however, the surface area of the resulting floating gate electrode 6 preferably has constant accuracy.

Next, a process of manufacturing the nonvolatile memory element 1 will be described.

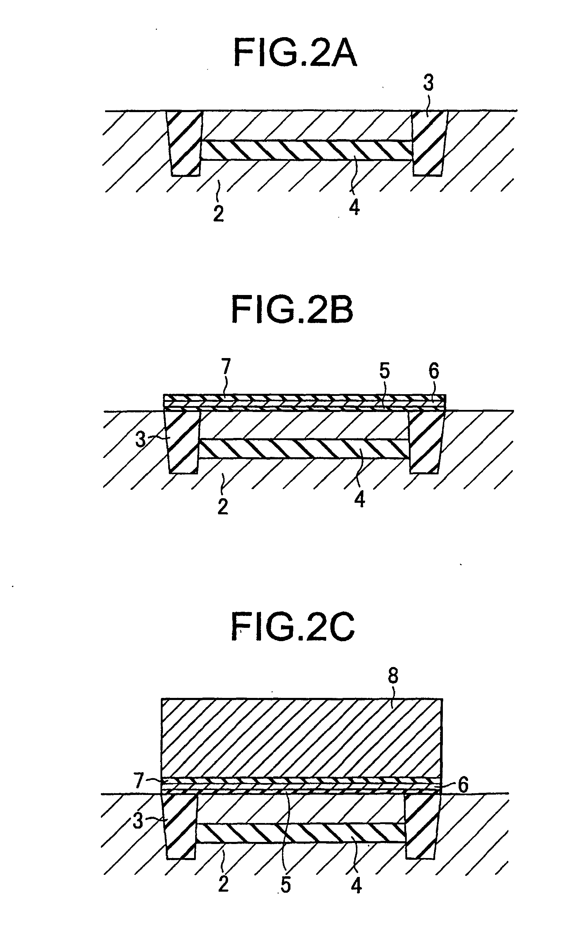

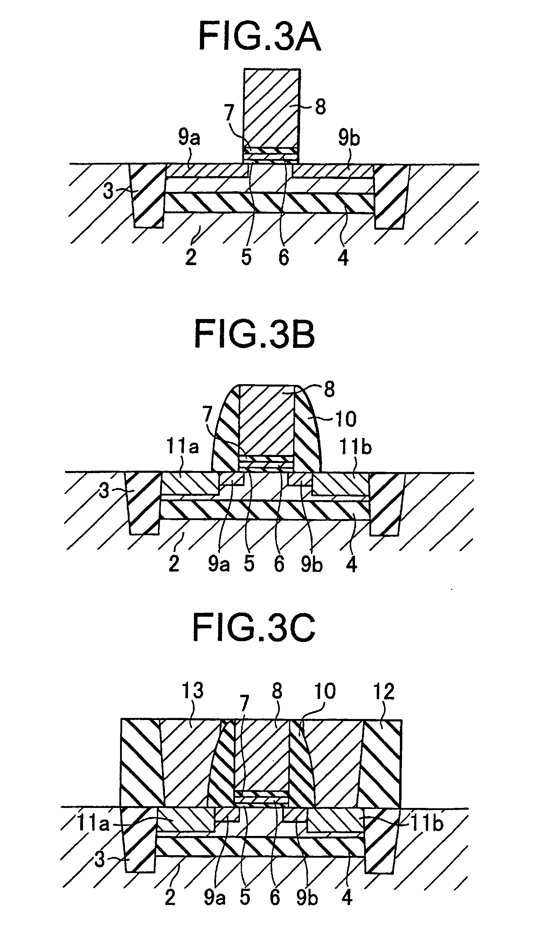

Figs. 2A to 2C and Figs. 3A to 3C are cross-sectional structural views for explaining the process of manufacturing the nonvolatile memory element 1.

The process of manufacturing the nonvolatile memory element 1 is mainly comprised of a tunnel oxide film forming step of forming the tunnel oxide film 5 on the Si substrate 2 which is a semiconductor substrate to be a base; a floating gate electrode forming step of forming, on the tunnel oxide film 5, the floating gate electrode 6 having an irregular shape on its own surface; an interlayer dielectric forming step of forming the interlayer dielectric 7 on the floating gate electrode 6; a control electrode forming step of forming the control electrode 8 on the interlayer dielectric 7; a gate electrode etching step of etching, in order to form a gate electrode, the tunnel oxide film 5, the floating gate electrode 6, the interlayer dielectric 7 and the control electrode 8; a low concentration drain forming step of forming the low concentration drains 9a and 9b; a gate sidewall forming step of forming the gate sidewall 10; a source and drain forming step of forming the source 11a and the drain 11b; an interlayer film forming step of forming the interlayer film 12; and a plug forming step of the plug 13.

Each step will be described hereafter.

When manufacturing the nonvolatile memory element 1, firstly, as shown in Fig. 2A, the element isolation layer 3 is formed in the Si substrate 2 by means of shallow trench isolation and the like, then the embedded layer 4 for adjusting a threshold voltage is formed by means of a conventional ion implantation process.

Next, the Si substrate 2 is thermally oxidized at about 800°C for about 15 minutes so that, as shown in Fig. 2B, the tunnel oxide film 5 having a thickness of about 8 nm is formed on a surface of the Si substrate 2 (the tunnel oxide film forming step). Then, polycrystalline Si or the like is deposited on the tunnel oxide film 5 by means of a chemical vapor deposition (CVD) process which is carried out in a situation where oxygen is removed from an air-tight CVD apparatus, so that the floating gate electrode 6 having an irregular shape of a substantial hemisphere (hemispherical polysicon: Hemispherical Grain) on its own surface as shown in Fig. 1B is formed (the floating gate electrode forming step). To form such hemispherical polysicon, an amorphous silicon is deposited on a surface of the tunnel oxide film 5 at a temperature of about 550°C for about 40 minutes by means of a chemical vapor deposition (CVD) process using silane (SiH₄) within a CVD apparatus which is applicable to a ultra-high vacuum, for example, so that an amorphous silicon film of about 100 nm is formed. Further, an annealing is carried out for about 10 minutes so as to grow hemispherical polysicon up to about 10 nm to 20 nm in grain diameter.

After formation of the floating gate electrode 6, the highly reliable interlayer dielectric 7 of SiO₂, Si₃N₄ or the like is grown on a surface of the floating gate electrode 6 up to about 15 nm by means of a film forming process to provide an ultra thin and ultra even film, such as an atomic layer chemical vapor deposition (AL-CVD) process (the interlayer dielectric forming step). Notably, the interlayer dielectric 7 formed in this step is preferably configured to have an even thickness to cover the hemisphere polysicon of the floating gate electrode 6.

After formation of the interlayer dielectric 7, a polycrystalline Si, a WSi or the like having a high concentration of phosphorus and the like is deposited on a surface of the interlayer dielectric 7 by means of a conventional LP-CVD and the like so as to form the control electrode 8 as shown in Fig. 2C (the control electrode forming step). Then, patterning of the control electrode 8 as shown in Fig. 3A is carried out by means of conventional lithographic technology and RIE technology (the gate electrode etching step). By this gate electrode etching step, the tunnel oxide film 5, the floating gate electrode 6, the interlayer dielectric 7 and the control electrode 8 which are respectively formed by the tunnel oxide film forming step, the floating gate electrode forming step, the interlayer dielectric forming step and the control electrode forming step are etched so as to form the gate electrode.

Using the patterned control electrode 8 as a mask, impurities such as phosphorus, arsenic, etc. are implanted by an ion implantation process at a concentration of 5 × 10¹³ /cm², for example, so as to form the low concentration drains 9a and 9b (the low concentration drain forming step).

Then, as shown in Fig. 3B, the gate sidewalls 10 are formed by means of conventional CVD and etch back processes (the gate sidewall forming step). Using the gate sidewalls 10 as masks, impurities such as phosphorus, arsenic, etc. are implanted by an ion implantation process at a concentration of 5 × 10¹⁵ /cm², for example. so as to form a source 11a and a drain 11b (the source and drain forming step).

Finally, in order to activate the implanted impurities, heat treatment at about 900°C for about 30 minutes by means of a conventional electric heating furnace or heat treatment at about 1050°C for 10 seconds by means of rapid thermal processing (RTP) is carried out to form the interlayer film 12 of Si oxide film to be a connecting portion of the source 11a or the drain 11b (the interlayer film forming step); and the plug 13 of W or polycrystalline Si is formed (the plug forming step), thereby constructing the nonvolatile memory element 1 as shown in Fig. 3C.

As described above, the nonvolatile memory element 1 is configured to have the floating gate electrode 6 where the hemisphere polysicon is formed on its surface and the interlayer dielectric 7 formed on the hemisphere polysicon to be highly even, so that the surface area of the floating gate electrode 6 is larger, to thereby increase the static capacity between the control electrode 8 and the floating gate electrode 6. Thus, a ratio (a coupling ratio) of the static capacity between the control electrode 8 and the floating gate electrode 6 to the whole static capacity of the floating gate electrode 6 can be increased so that an applied voltage between the Si substrate 2 and the floating gate electrode 6 can be increased without increasing a write voltage to the whole nonvolatile memory element 1.

As described above, in the embodiment, the nonvolatile memory element 1 is configured by forming the tunnel oxide film 5 on the Si substrate 2 to be a base; forming the floating gate electrode 6 on the tunnel oxide film 5 to have hemisphere polysicon on its own surface; forming the highly even interlayer dielectric 7 on the floating gate electrode 6; and forming the control electrode 8 on the interlayer dielectric 7, so that the coupling ratio is increased, whereby the applied voltage between the Si substrate 2 and the floating gate electrode 6 can be increased without increasing the write voltage to the whole nonvolatile memory element 1.

Therefore, it becomes possible to decrease the write voltage for the nonvolatile memory element 1, and further, it becomes possible to decrease a withstanding voltage required for the drain, so that the element can be miniaturized. Further, since the nonvolatile memory element 1 is configured to be an FG type, sufficient density of storing charge, data retention time and endurance characteristics of write/erase may also be obtained.

Next, a second embodiment according to the present invention will be described.

The present embodiment is an application to the first embodiment and is different from the first embodiment in a configuration of a floating gate electrode 30 and an interlayer dielectric 31.

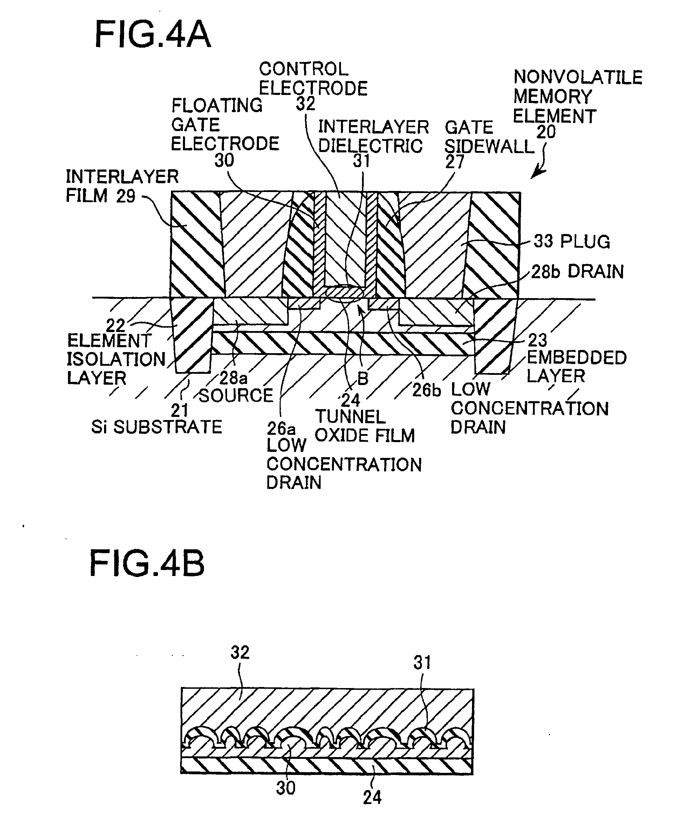

Figs. 4A to 4B are structural views showing a structure of a nonvolatile memory element 20 according to the present embodiment. Fig. 4A shows a cross-sectional view of the nonvolatile memory element 20, and Fig. 4B shows an enlarged cross-sectional view of a portion B in Fig. 4A.

The nonvolatile memory element 20 is an FG type nonvolatile memory element which is utilized as a flash memory, for example, and is mainly comprised of a Si substrate 21 which is a semiconductor substrate to be a base; an element isolation layer 22; an embedded layer 23 provided in the Si substrate 21 so as to adjust a threshold voltage; a tunnel oxide film 24 formed on the Si substrate 21; a floating gate electrode 30 formed on the tunnel oxide film 24 so as to have an irregular shape on its own surface; an interlayer dielectric 31 formed on the floating gate electrode 30; a control electrode 32 provided on the interlayer dielectric 31; low concentration drains 26a and 26b formed at a surface of the Si substrate 21; a source 28a; a drain 28b; a gate sidewall 27 formed on an upper surface of the Si substrate 21; an interlayer film 29; and a plug 33.

Herein, the floating gate electrode 30 and the interlayer dielectric 31 are formed so as to surround a bottom surface and sidewalls of the control electrode 32, which are different from the first embodiment. Thus, comparing with the first embodiment, it becomes possible to increase a ratio (a coupling ratio) of a static capacity between the control electrode 32 and the floating gate electrode 30 to the whole static capacity of the floating gate electrode 30.

As shown in Fig. 4B, the floating gate electrode 30 of the nonvolatile memory element 20 is formed to have the irregular shape on its own surface so that a surface area of the floating gate electrode 30 can be increased and a static capacity between the floating gate electrode 30 and the control electrode 32 can be increased. The irregular shape may be of a substantial hemisphere such as a mushroom shape, a waveform, or any other rugged shape, however, the surface area of the resulting floating gate electrode 30 preferably has constant accuracy.

Then, a process of manufacturing the nonvolatile memory element 20 will be described.

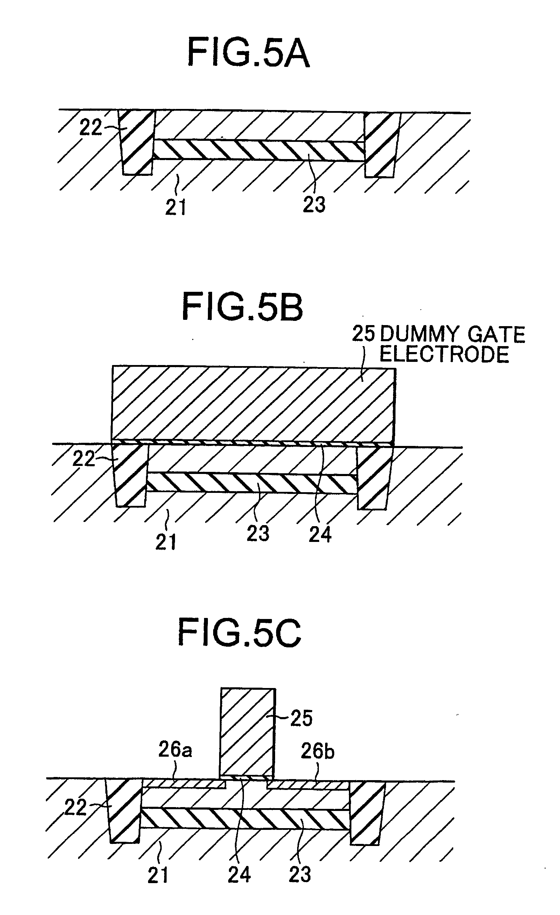

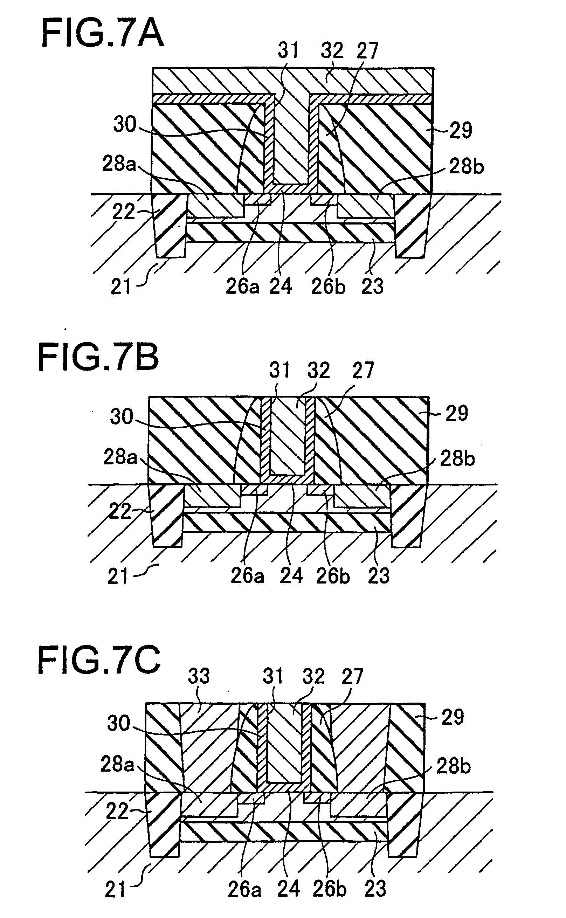

Figs. 5A to 5C and Figs. 7A to 7C are cross-sectional structural views for explaining the process of manufacturing the nonvolatile memory element 20.

The process of manufacturing the nonvolatile memory element 20 is mainly comprised of a tunnel oxide film forming step of forming the tunnel oxide film 24 on a Si substrate 21 which is a semiconductor substrate to be a base; a dummy gate electrode forming step of forming a dummy gate electrode 25 on the tunnel oxide film 24; a dummy gate electrode etching step of etching the dummy gate electrode 25; a low concentration drain forming step of forming the low concentration drains 26a and 26b; a gate sidewall forming step of covering a side of the dummy gate electrode 25 with the gate sidewall 27; a source and drain forming step of forming the source 28a and the drain 28b; an interlayer film forming step of forming the interlayer film 29; a dummy gate electrode removing step of removing the dummy gate electrode 25; a floating gate electrode forming step of forming the floating gate electrode 30 having an irregular shape on its own surface; an interlayer dielectric forming step of forming the interlayer dielectric 31 on the floating gate electrode 30; a control electrode forming step of forming the control electrode 32 on the interlayer dielectric 31; a planarization step of removing the floating gate electrode 30 except for a gate portion, the interlayer dielectric 31, and the control electrode 32; and a plug forming step of forming the plug 33.

Each step will be described hereafter.

When manufacturing the nonvolatile memory element 20, firstly, as shown in Fig. 5A, the element isolation layer 22 is formed at the Si substrate 21 by means of shallow trench isolation and the like, then the embedded layer 23 for adjusting a threshold voltage is formed by means of a conventional ion implantation process.

Next, the Si substrate 21 is thermally oxidized at about 800°C for about 15 minutes so that, as shown in Fig. 5B, the tunnel oxide film 24 of about 8 nm is formed at a surface of the Si substrate 21 (the tunnel oxide film forming step). Using a conventional process such as LP-CVD process, a polycrystalline Si film is deposited up to about 600 nm so as to form the dummy gate electrode 25 (the dummy gate electrode forming step).

Then, the resulting layered structure is processed by means of a conventional lithographic technology and a conventional RIE technology so that a pattern of the dummy gate electrode 25 as shown in Fig. 5C is formed (the dummy gate electrode etching step). After patterning of the dummy gate electrode 25, using the dummy gate electrode 25 as masks, impurities such as phosphorus, arsenic, etc. are implanted by an ion implantation process at a concentration of 5 × 10¹³/cm², for example, so as to form the low concentration drains 26a and 26b (the low concentration drain forming step).

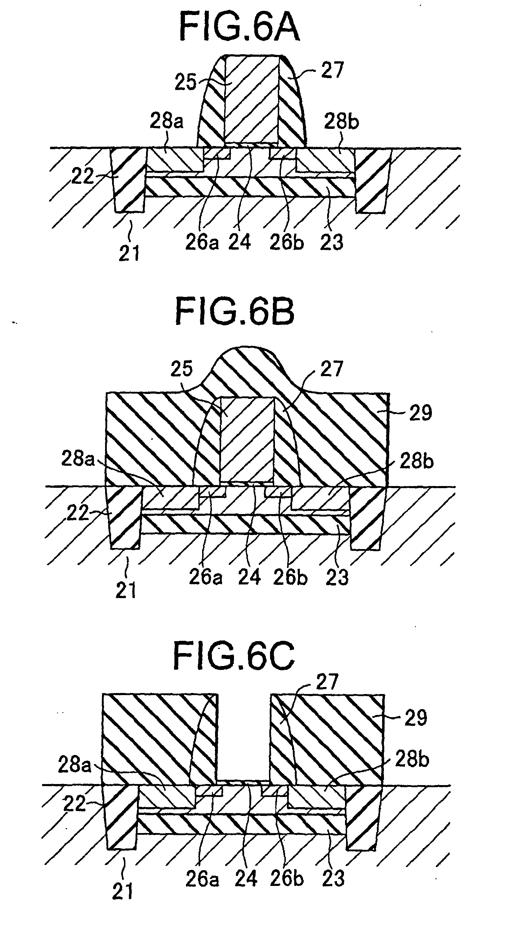

Then, as shown in Fig. 6A, the gate sidewalls 27 are formed by means of conventional CVD and etch back processes (the gate sidewall forming step). Using the gate sidewalls 27 as masks, impurities such as phosphorus, arsenic, etc. are implanted by an ion implantation process at a concentration of 5 × 10¹⁵ /cm², for example, so as to form the source 28a and the drain 28b (the source and drain forming step).

In order to activate the implanted impurities, heat treatment at about 900°C for about 30 minutes by means of a conventional electric heating furnace or heat treatment at about 1050°C for 10 seconds by means of rapid thermal processing (RTP) is carried out to deposit the interlayer film 29 of Si oxide film etc. as shown in Fig. 6B (the interlayer film forming step).

Then, as shown in Fig. 6C, by using a planarization technology such as a CMP for a conventional insulating film, a surface of the interlayer film 29 is planarized and the dummy gate electrode 25 is exposed so that the dummy gate electrode 25 is removed by a conventional etching process (the dummy gate electrode removing step).

Subsequently, as shown in Fig. 7A, polycrystalline Si or the like is deposited on a surface of the tunnel oxide film 24 and a side of the gate sidewall 27 by means of a chemical vapor deposition process which is carried out in a situation where oxygen is removed from an air-tight CVD apparatus, so that the floating gate electrode 30 having an irregular shape of a substantial semicircle (hemispherical polysicon: Hemispherical Grain) on its own surface as shown in Fig. 4B is formed (the floating gate electrode forming step).

The formation of the floating gate electrode 30 is carried out along an inner sidewall of the gate sidewall 27 and an upper surface of the interlayer film 29. The formation of such hemispherical polysicon is carried out in such a manner that an amorphous silicon is deposited on the tunnel oxide film 24 at a temperature of about 550°C for about 40 minutes by means of a chemical vapor deposition process using silane (SiH₄) within a CVD apparatus which is applicable to a ultra-high vacuum, for example so as to form an amorphous silicon film up to about 100 nm, then an annealing is carried out for about 10 minutes so as to grow hemispherical polysicon up to about 10 nm to 20 nm in grain diameter.

After formation of the floating gate electrode 30, the ultra even and highly reliable interlayer dielectric 31 of SiO₂, Si₃N₄ or the like is deposited up to about 15 nm along a surface (an inner surface of a sidewall) of the floating gate electrode 30 by means of an atomic layer chemical vapor deposition process at about 400°C (the interlayer dielectric forming step). A polycrystalline Si doped with phosphorus and the like is deposited on its surface so as to form the control electrode 32 (the control electrode forming step). Notably, the formation of SiO₂ layer out of the interlayer dielectric 31 may not be carried out by an atomic layer chemical vapor deposition process but may be carried out in a manner that after the hemispherical polysicon of the floating gate electrode 30 are thermally oxidized, Si₃N₄ is deposited on a surface thereof by an atomic layer chemical vapor deposition process, for example, then the Si₃N₄ is oxidized again.

Subsequently, as shown in Fig. 7B, these are planarized; the floating gate electrode 30 except for a gate portion, the interlayer dielectric 31, and the control electrode 32 are removed (the planarization step); and finally, as shown in Fig. 7C the plug 33, of a polycrystalline Si etc., to be a connecting portion of the source 28a and the drain 28b is formed (the plug forming step).

As described above, since the nonvolatile memory element 20 is configured in such a manner that the floating gate electrode 30 and the interlayer dielectric 31 surround a bottom surface and sides of the control electrode 32, the static capacity between the control electrode 32 and the floating gate electrode 30 can be larger than that of the first embodiment.

As described above, in the present embodiment, since the floating gate electrode 30 is formed to surround the bottom surface and the sides of the control electrode 32, so as to configure the nonvolatile memory element 20, a ratio (a coupling ratio) of a static capacity between the control electrode 32 and the floating gate electrode 30 to the whole static capacity of the floating gate electrode 30 can be significantly increased, and an applied voltage between the Si substrate 21 and the floating gate electrode 30 can be increased without increasing an applied voltage to the whole nonvolatile memory element 20, thereby enabling the applied voltage to the whole nonvolatile memory element 20 to be reduced.

Further, a drain withstanding voltage required for the drain can be decreased so that it becomes possible to miniaturize the element.

Further, since the nonvolatile memory element 20 is configured to be an FG type, sufficient density of storing charge, data retention time and endurance characteristics of write/erase may also be obtained.

As an example, when comparison is made in a typical FG type nonvolatile memory element of the 0.18 µm generation having a gate length of 0.18 µm, a gate width of 1.0 µm, and a gate height of 0.6 µm, an FG type nonvolatile memory element of a conventional configuration provides a coupling ratio of about 0.36, whereas the nonvolatile memory element 20 according to the present embodiment provides a coupling ratio of about 0.9, thereby increasing the coupling ratio up to almost 2.5 times. Therefore, when a required write voltage for the nonvolatile memory element of the conventional configuration is about 20 V, a write voltage of about 8.7 V can be utilized for writing in the present embodiment.

It should be noted that the present invention is not limited to the embodiments as described above. For example, in the first and the second embodiments, although the highly even interlayer dielectric is formed on the surface of the floating gate electrode having hemispherical polysicon by using an atomic layer chemical vapor deposition process, the interlayer dielectric may be formed by means of any manufacturing process other than such an atomic layer chemical vapor deposition process as far as it can form an ultra thin layer in a substantially conformal manner.

As described above, according to the present invention, the FG type nonvolatile memory element is configured by forming the tunnel oxide film on the Si substrate which is a semiconductor substrate to be a base; forming the floating gate electrode on the tunnel oxide film to have an irregular shape on its own surface; forming the highly even interlayer dielectric on the floating gate electrode having the irregular shape; and forming the control electrode on the interlayer dielectric, thereby maintaining sufficient density of stored charges, data retention time, and endurance characteristics of write/erase, and at the same time enabling a write voltage to decrease and the element itself to be miniaturized.

## Claims

1. In a nonvolatile memory element which retains data regardless of whether power supply for the element is on or off, said nonvolatile memory element is **characterized by** comprising:
a semiconductor substrate to be a base;
a tunnel oxide film formed on said semiconductor substrate;
a floating gate electrode formed on said tunnel oxide film so as to have an irregular shape on a surface thereof;
an interlayer dielectric formed on said floating gate electrode; and
a control electrode formed on said interlayer dielectric.

2. The nonvolatile memory element according to claim 1, **characterized in that** said irregular shape is a substantially hemispherical shape.

3. The nonvolatile memory element according to claim 2, **characterized in that** a grain diameter of said irregular shape ranges from 10 nm to 20 nm.

4. The nonvolatile memory element according to claim 1, **characterized in that** said interlayer dielectric is formed by using an atomic layer chemical vapor deposition process.

5. The nonvolatile memory element according to claim 1,
**characterized in that** said floating gate electrode and said interlayer dielectric are formed so as to surround a bottom surface and sides of said control electrode.

6. The nonvolatile memory element according to claim 1, **characterized by** being for a flash memory.

7. In a method of manufacturing a nonvolatile memory element which retains data regardless of whether power supply for the element is on or off, said method of manufacturing a nonvolatile memory element is **characterized by** comprising:
a tunnel oxide film forming step of forming a tunnel oxide film on a semiconductor substrate to be a base;
a floating gate electrode forming step of forming, on the tunnel oxide film, a floating gate electrode having an irregular shape on a surface thereof;
an interlayer dielectric forming step of forming an interlayer dielectric on the floating gate electrode; and
a control electrode forming step of forming a control electrode on the interlayer dielectric.

8. The method of manufacturing a nonvolatile memory element according to claim 7, **characterized in that** said interlayer dielectric forming step is carried out to form the interlayer dielectric by using an atomic layer chemical vapor deposition process.

9. The method of manufacturing a nonvolatile memory element according to claim 7, **characterized by** further comprising:
a gate electrode etching step of etching the tunnel oxide film, the floating gate electrode, the interlayer dielectric, and the control electrode which are formed by said tunnel oxide film forming step, said floating gate electrode forming step, said interlayer dielectric forming step, and said control electrode forming step so as to form a gate electrode.

10. The method of manufacturing a nonvolatile memory element according to claim 7, **characterized by** further comprising:
a dummy gate electrode forming step of forming a dummy gate electrode on the tunnel oxide film subsequent to said tunnel oxide film forming step;
a dummy gate electrode etching step of etching the dummy gate electrode;
a gate sidewall forming step of covering a sidewall of the dummy gate electrode with a gate sidewall; and
a dummy gate electrode removing step of removing the dummy gate electrode subsequent to forming the gate sidewall, wherein said floating gate electrode forming step is carried out to form the floating gate electrode along an inner sidewall of the gate sidewall, and said interlayer dielectric forming step is carried out to form the interlayer dielectric along an inner sidewall of the floating gate electrode.
